# EUROPEAN PATENT SPECIFICATION

(11) **EP 2 749 409 B1**
(45) Date of publication and mention of the grant of the patent: **17.07.2019**
(21) Application number: 12826000.7
(22) Date of filing: 23.08.2012
(51) Int. Cl.: B32B 9/00, B65D 30/02, B65D 65/40, H01L 31/042, H01L 51/50, H05B 33/02, H05B 33/04, H05B 33/10, G03F 7/027, G03F 7/075, H01L 51/44, H01L 51/52

(54) **BARRIER LAMINATE, AND GAS BARRIER FILM**
SPERRSCHICHTLAMINAT UND GASSPERRSCHICHT
STRATIFIÉ FORMANT BARRIÈRE ET FILM FORMANT BARRIÈRE AUX GAZ

(30) Priority: 24.08.2011 JP 2011183156
(43) Date of publication of application: 02.07.2014
(73) Proprietor: FUJIFILM Corporation, Tokyo 106-8620 (JP)
(72) Inventor: IWASE Eijiro, Ashigarakami-gun Kanagawa 258-8577 (JP); MUKAI Atsushi, Ashigarakami-gun Kanagawa 258-8577 (JP); TSUKAHARA Jiro, Ashigarakami-gun Kanagawa 258-8577 (JP)
(74) Representative: Hoffmann Eitle
(86) International application number: PCT/JP2012/071252
(87) International publication number: WO 2013/027786

(56) References cited:
- EP-A1- 2 028 184
- EP-A2- 1 351 321
- JP-A- H11 310 755
- JP-A- 2001 125 079
- JP-A- 2005 007 741
- JP-A- 2005 199 697
- JP-A- 2007 098 677
- JP-A- 2009 067 778
- JP-A- 2010 089 396
- US-A1- 2011 147 955

## Description

### Technical Field

The present invention relates to a barrier laminate and to a gas barrier film employing the same. The present invention further relates to various devices employing barrier laminates and gas barrier films. Still further, the present invention relates to methods for manufacturing gas barrier films and devices.

### Background Art

Barrier laminates comprised of an inorganic layer and of an organic layer have been known for some time. For example, an organic layer can be formed by coating on a support (such as PET or PEN), and an inorganic layer can be laminated on the organic layer by vacuum film formation to form a uniform inorganic layer without affecting the smoothness of the base. By repeating these operations, it is possible to form a high performance gas barrier film. However, it is difficult to ensure adhesion between layers in a laminate structure of organic and inorganic layers. That is because, even when forming an organic layer over an inorganic layer, the density of the inorganic layer prevents the coating liquid being employed to form the organic layer from penetrating into the inorganic layer the way it does when coated on a highly adhesive layer.

Due to such problems, the use of silane coupling agents has been studied as a method of enhancing adhesion between organic and inorganic layers when coating an organic layer on an inorganic layer (Patent Reference 1). Silane coupling agents are normally added to the coating liquid used to form the organic layer, and form covalent bonds with the inorganic layer beneath the organic layer. As a result, adhesion between the inorganic layer and organic layer is enhanced.

Patent documents EP1351321 (A) and US2011147955 (A) disclose a support which can be used for a display or an electronic device, and an organic electroluminescent element employing the support.

[Patent Reference 1] Japanese Unexamined Patent Publication (KOKAI) No. 2001-125079

### Summary of Invention

### Problem to Be Solved by the Invention

Investigation by the present inventors has revealed that when a barrier laminate was fabricated using the silane coupling agent described in Patent Reference 1, although adhesion between the organic layer and the inorganic layer was enhanced, the barrier property when incorporated into a device such as an organic EL element was not necessarily adequate. The present invention, devised to solve this problem, has as its object to provide a barrier laminate affording both good adhesion between an organic layer and an inorganic layer and good barrier properties.

### Means of Solving the Problem

The present inventors conducted extensive research into solving the above problem. As a result, they found that heat was applied in the course of incorporation into a device such as an organic EL element, and that this application of heat was a problem. That is, when an organic layer is formed using a silane coupling agent, alcohol remains in the organic layer as a residual component of hydrolysis of the silane coupling agent. Heat was found to convert the alcohol into a gas, compromising the barrier property. That is, the gas generated results from the alcohol, and its composition is close to that of water. At the instant when the alcohol departs in the form of a gas, a portion thereof ends up being broken down into water. That is, the alcohol and water have been found to impart the same negative effect as when moisture from the outside penetrates the barrier laminate. Additional research conducted into this problem by the present inventors revealed that by using a silane coupling agent of specific structure in the organic layer, it was possible to enhance adhesion. The present invention was devised on that basis. Specifically, it was devised based on <1>, preferably <2> to <11> below.
<1> A barrier laminate comprising an inorganic layer and an organic layer disposed on the surface of the inorganic layer, wherein the organic layer comprises a silane coupling agent denoted by general formula (1) below: 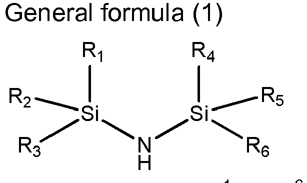
   wherein each of R¹ to R⁶ denotes a substituted or unsubstituted alkyl group or aryl group, provided that at least one from among R¹ to R⁶ is a substituent containing a (meth)acryloyloxy group; and
   wherein the inorganic layer comprises a metal oxide, nitride, or oxynitride of Si or Al.
<2> A barrier laminate comprising an inorganic layer and an organic layer disposed on the surface of the inorganic layer according to <1>, wherein the organic layer is a layer obtained by curing a polymerizable composition comprising a polymerizable compound, the silane coupling agent denoted by general formula (1), and a polymerization initiator:
<3> The barrier laminate according to <2>, wherein the polymerizable compound is a (meth)acrylate compound.
<4> The barrier laminate according to any one of <1> to <3>, wherein the alkyl group is methyl group and the aryl group is phenyl group.
<5> The barrier laminate according to any one of <1> to <4>, which comprises a second inorganic layer on the surface of the organic layer.
<6> The barrier laminate according to any one of <1> to <5>, wherein at least two organic layers and two inorganic layers are laminated in alternating fashion.
<7> A gas barrier film, comprising the barrier laminate according to any one of <1> to <6> disposed on a support.
<8> A device wherein the gas barrier film according to <7> is employed as a substrate.
<9> The device according to <8>, wherein the device is an organic EL element or a solar cell element.
<10> A sealing bag, employing the barrier laminate according to any one of <1> to <6> or the gas barrier film according to <7>.
<11> A method of manufacturing the gas barrier film according to <7>, which comprises:
   applying a polymerizable composition comprising a polymerizable compound, the silane coupling agent denoted by general formula (1), and a polymerization initiator on a support;
   heating to a temperature of 25°C or higher; and
   curing with light rays, an electron beam, or heat.

### Effect of the Invention

The present invention makes it possible to provide a barrier laminate, which maintains both barrier properties and adhesion between an organic layer and an inorganic layer, even when incorporated into an element.

### Brief Description of the Drawings

Figure 1 is a sectional schematic showing an example of the barrier laminate of the present invention.
Figure 2 is a sectional schematic showing how gas is released by a conventional barrier laminate.
Figure 3 is a sectional schematic showing an example of the configuration of the gas barrier film of the present invention.

### Modes of Carrying Out the Invention

The present invention is described in detail below. In the present Description, the word "to" is used in a manner including the preceding and succeeding numeric values as a lower limit and upper limit, respectively. In the present invention, the term "organic EL element" refers to an organic electroluminescent element. In the present Description, the term "(meth)acrylate" includes acrylate and methacrylate.

The barrier laminate of the present invention comprises an inorganic layer and an organic layer disposed on the surface of the inorganic layer according to the claims, and is characterized in that the organic layer either comprises the silane coupling agent denoted by general formula (1) below, or is obtained by curing a polymerizable composition comprising a polymerizable compound, the silane coupling agent denoted by general formula (1) below, and a polymerization initiator. In the present invention, the use of a silane coupling agent such as that denoted by general formula (1) in the organic layer of the barrier laminate makes it possible to achieve a good water vapor barrier property while maintaining good adhesion following incorporation into a device.

The silane coupling agent employed in the present invention will be described first. 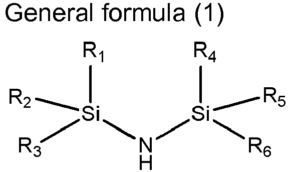 In general formula (1), each of R¹ to R⁶ denotes a substituted or unsubstituted alkyl group or aryl group, with at least one from among R¹ to R⁶ being a substituent containing a (meth)acryloyloxy group.

Each of R¹ to R⁶ denotes a substituted or unsubstituted alkyl group or aryl group. With the exception of when they denote substituents containing radical polymerizable carbon-carbon double bonds, R¹ to R⁶ are preferably unsubstituted alkyl groups or unsubstituted aryl groups. Alkyl groups in the form of alkyl groups having 1 to 6 carbon atoms are preferable, with methyl groups being more preferable. Aryl groups in the form of phenyl groups are preferable. Methyl groups are particularly preferable as R¹ to R⁶.

At least one from among R¹ to R⁶ comprises a substituent containing a (meth)acryloyloxy group, with two from among R¹ to R⁶ being substituents comprising radical polymerizable carbon-carbon double bonds. It is particularly preferable for one from among R¹ to R³ to comprise a substituent containing a radical polymerizable carbon-carbon double bond, and for one from among R⁴ to R⁶ to comprise a substituent containing a radical polymerizable carbon-carbon double bond, provided that at least one from among R¹ to R⁶ comprises a substituent containing a (meth)acryloyloxy group.

Two or more substituents comprising radical polymerizable carbon-carbon double bonds that are contained in the silane coupling agent denoted by general formula (1) may be identical or different, but are preferably identical.

The substituent comprising a radical polymerizable carbon-carbon double bond can be denoted by -X-Y. Here, X denotes a single-bond 1-to-6-carbon alkylene or arylene group, preferably a single-bond methylene, ethylene, propylene, or phenylene group. Y denotes a radical polymerizable carbon-carbon double-bond group, preferably an acryloyloxy group, methacryloyloxy group, acryloylamino group, methacryloylamino group, vinyl group, propenyl group, vinyloxy group, or vinylsulfonyl group, and preferably a (meth)acryloyloxy group.

R¹ to R⁶ may comprise substituents in addition to the substituents containing radical polymerizable carbon-carbon double bonds. Examples of such substituents are alkyl groups (such as methyl groups, ethyl groups, isopropyl groups, tert-butyl groups, n-octyl groups, n-decyl groups, n-hexadecyl groups, cyclopropyl groups, cyclopentyl groups, and cyclohexyl groups); aryl groups (such as phenyl groups and naphthyl groups); halogen atoms (such as fluorine, chlorine, bromine, and iodine atoms); acyl groups (such as acetyl groups, benzoyl groups, formyl groups, and pivaloyl groups); acryloxy groups (such as acetoxy groups, acryloyloxy groups, and methacryloyloxy groups); alkoxycarbonyl groups (such as methoxycarbonyl groups and ethoxycarbonyl groups); aryloxycarbonyl groups (such as phenyloxycarbonyl groups); and sulfonyl groups (such as methanesulfonyl groups and benzenesulfonyl groups).

Specific examples of the compound denoted by general formula (1) are given below. However, the present invention is not limited thereto.

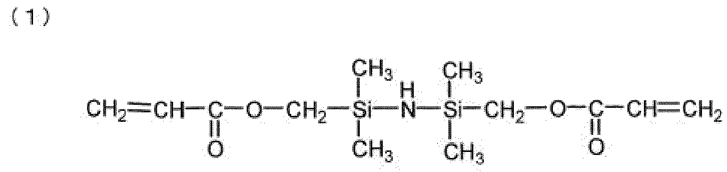

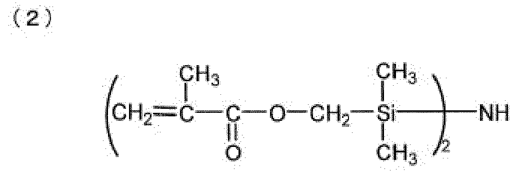

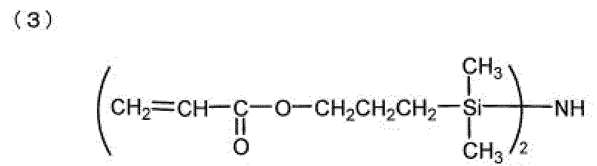

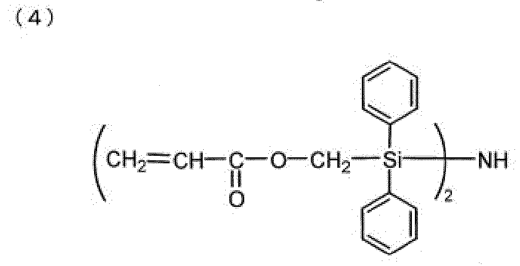

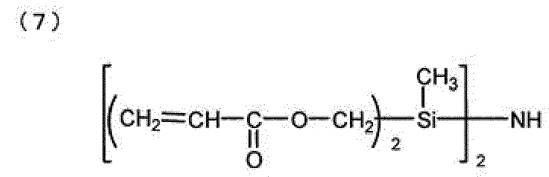

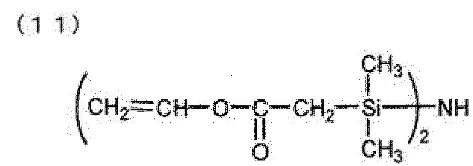

The silane coupling agent employed in the present invention is preferably contained in the polymerizable composition, described further below, in a proportion of from 1 to 30 weight%, preferably 3 to 30 weight%, and more preferably, 5 to 25 weight%. When employed in such a proportion, it tends to enhance the effect of the present invention.

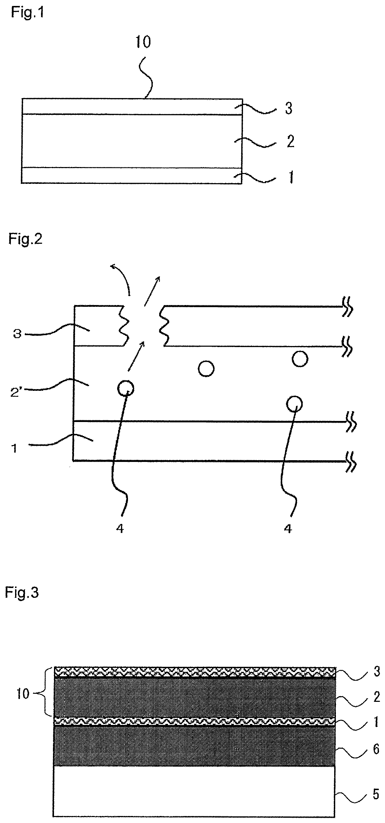

The barrier laminate of the present invention comprises an inorganic layer and an organic layer disposed on the surface of the inorganic layer. In a preferred form, a second inorganic layer is present on the surface of the organic layer. Figure 1 is a sectional schematic showing an example of the barrier laminate of such an embodiment in which 1 denotes an inorganic layer, 2 denotes an organic layer, 3 denotes a second inorganic layer, and 10 denotes the barrier laminate, respectively.

In the course of forming the organic layer, the composition comprising a polymerizable compound, a silane coupling agent, and a polymerization initiator is generally applied on the inorganic layer and cured. With regard to hydrolysis of the silane coupling agent that is described in Patent Reference 1 (Japanese Unexamined Patent Publication (KOKAI) No. 2001-125079), the acid value of the coating liquid is adjusted to control the reaction of the coating liquid. Following coating, heating at 80°C is conducted for 10 minutes to enhance adhesion.

However, investigation by the present inventors has revealed that when a silane coupling agent such as that described in Patent Reference 1 (Japanese Unexamined Patent Publication (KOKAI) No. 2001-125079) is employed, alcohol (methanol, ethanol) by-products of hydrolysis end up remaining in the organic layer. The residual alcohols have been found to release large amounts of gas in subsequent processes, such as during the stage of incorporation into a device. This tendency becomes pronounced during heating and degassing. Figure 2 is a schematic showing how gas is released by a conventional barrier laminate. The same numbers have been employed as in Figure 1. In a conventional organic layer 2', alcohol 4 remains. When heating or degassing is conducted in this state, the alcohol gas is released, compromising the gas barrier property. In particular, as in the embodiment shown in Figure 2, when an inorganic layer 3 is provided on the surface of the organic layer, inorganic layer 3 will sometimes end up breaking down. When the device in which the barrier laminate has been incorporated is exposed to a high temperature process of 100°C or higher, this trend due to residual by-products has been found to be pronounced.

By contrast, in the present invention, even when the silane coupling agent hydrolyzes, this particular silane coupling agent essentially produces no gas components other than ammonia. Thus, problems such as the above do not occur. That is, the barrier laminate of the present invention maintains good barrier properties even when processed at elevated temperature or under vacuum, ensuring adhesion between the organic layer and inorganic layer.

In Figures 1 and 2, there is only one organic layer 2. However, a second organic layer can also be present. That is, in the present invention, a configuration in which at least two organic layers and at least two inorganic layers are present in alternating fashion is preferable. Further, although the number of layers of the configuration of the barrier laminate is not specifically limited, 2 to 30 layers are conventionally preferable, and 3 to 20 layers are more preferable.

### (The organic layer)

The organic layer in the present invention is a polymer layer. The organic layer is preferably formed by forming a layer of a polymerizable composition comprising a polymerizable compound, a silane coupling agent, and a polymerization initiator and then curing the layer.

The layer of the polymerizable composition is normally formed by applying the polymerizable composition on a support such as a substrate film or an inorganic layer. Examples of the method of application include dipping method, air knife coating method, curtain coating method, roller coating method, wire bar coating method, gravure coating method, slide coating method, and the extrusion coating method employing a hopper that is described in US Patent 2,681,294. Of these, the extrusion coating method is preferably employed.

### (The polymerizable compound)

The polymerizable compound that is employed in the present invention is a compound having a terminal or side-chain ethylenic unsaturated bond, and/or a compound having a terminal or side-chain epoxy or oxetane. Of these, a compound having a terminal or side-chain ethylenic unsaturated bond is preferable. Examples of compounds having terminal or side-chain ethylenic unsaturated bonds include: (meth)acrylate compounds, acrylamide compounds, styrene compounds, and maleic anhydride. (Meth)acrylate compounds are preferable.

(Meth)acrylates, urethane (meth)acrylates, polyester (meth)acrylates, epoxy (meth)acrylates, and the like are preferable as (meth)acrylate compounds.

Styrenes, α-methylstyrene, 4-methylstyrene, divinylbenzene, 4-hydroxystyrene, 4-carboxystyrene, and the like are preferable as styrene compounds.

Specific examples of (meth)acrylate compounds are given below. However, the present invention is not limited thereto.

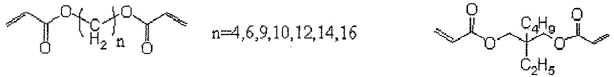

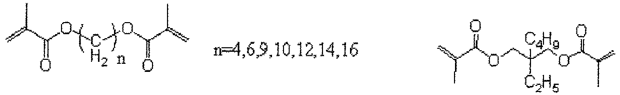

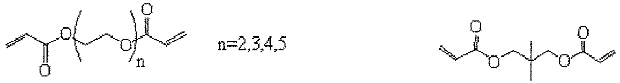

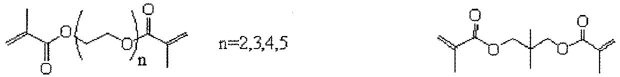

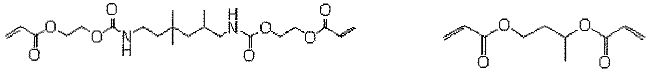

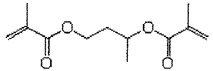

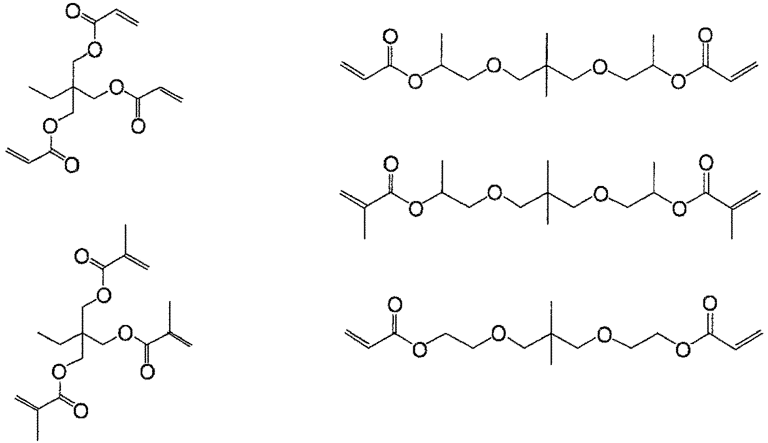

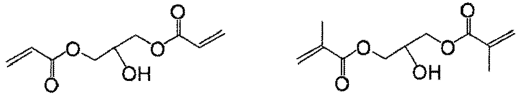

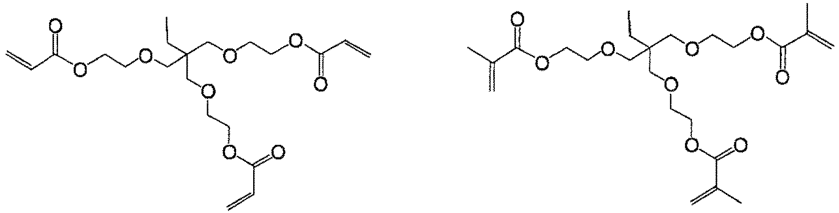

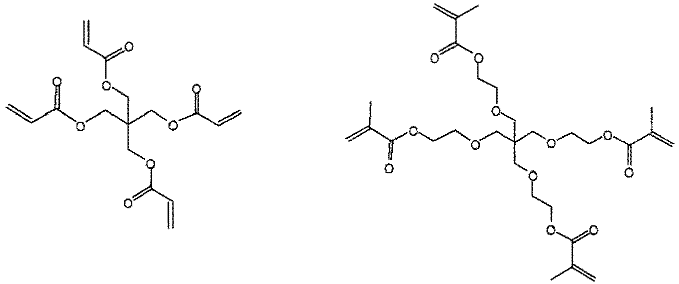

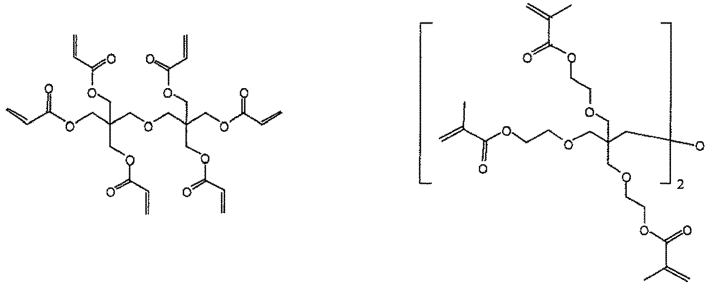

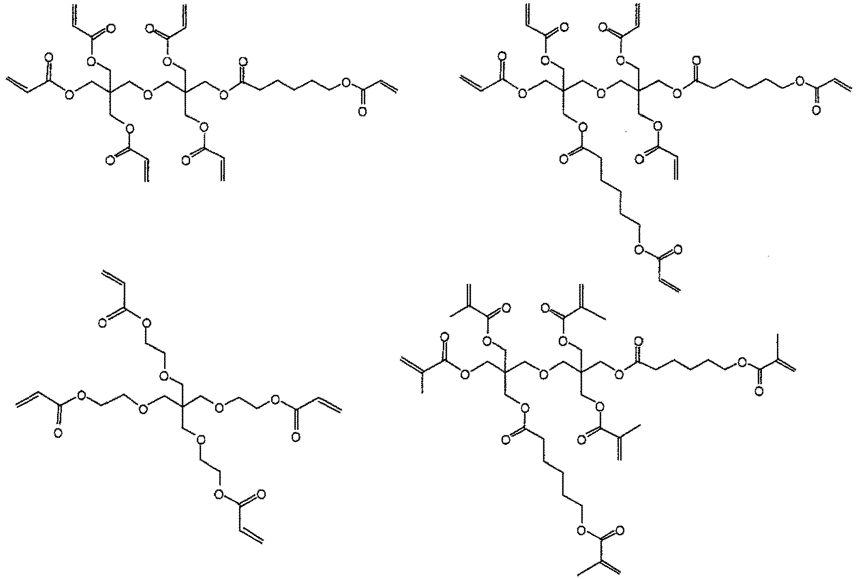

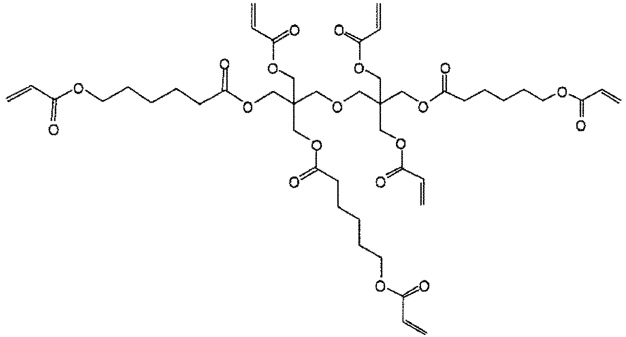

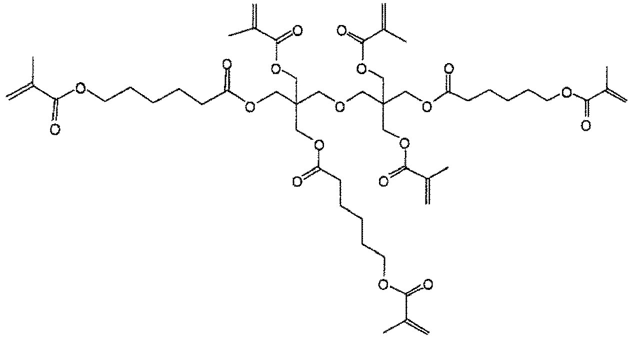

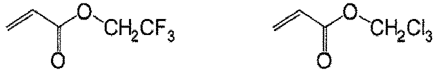

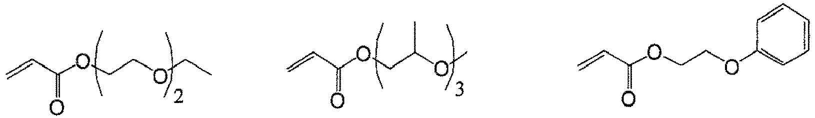

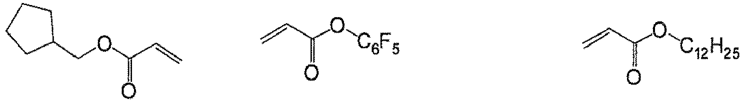

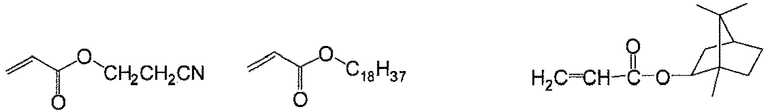

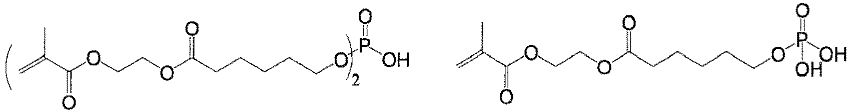

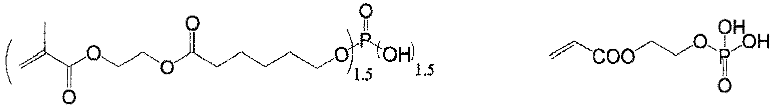

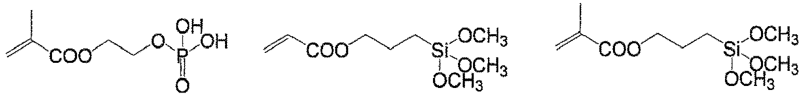

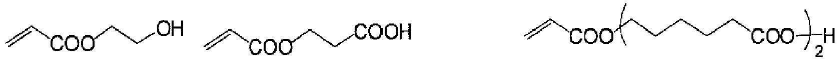

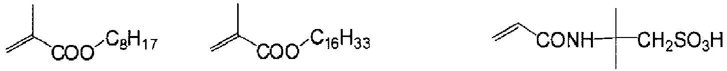

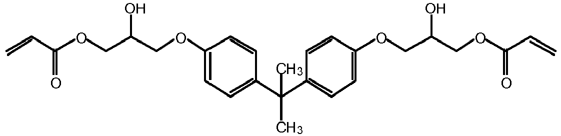

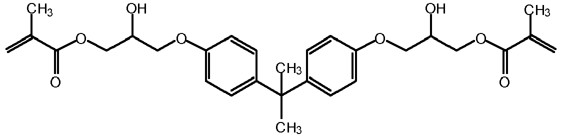

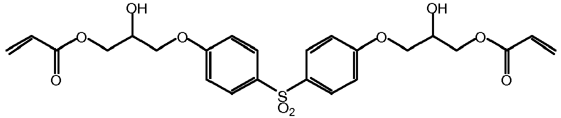

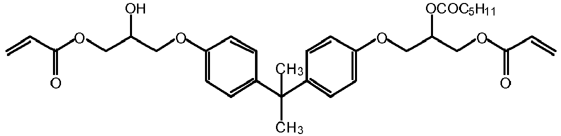

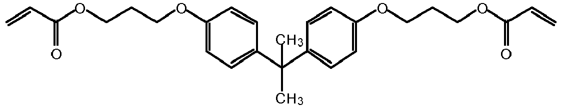

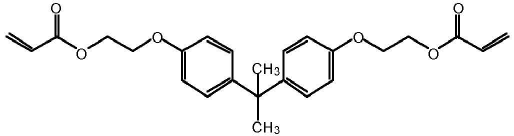

In the present invention, the methacrylate compound denoted by general formula (2) below is also preferably employed. 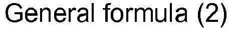 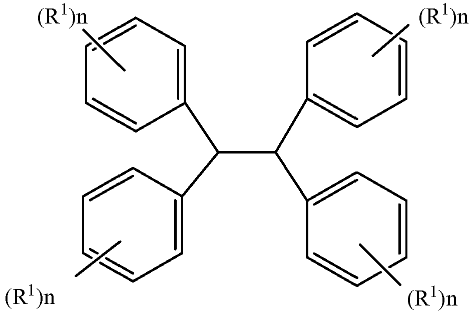 In general formula (2), R¹ denotes a substituent, the individual instances of which may be identical or different; and n denotes an integer of from 0 to 5, the individual instances of which may be identical or different. However, at least one instance of R¹ contains a polymerizable group.

Examples of the substituent of R¹ include groups comprised of a combination of a polymerizable group and one or more from among -CR²₂- (where R² denotes a hydrogen atom or a substituent), -CO-, -O-, a phenylene group, -S-, -C=C-, -NR³-(where R³ denotes a hydrogen atom or a substituent), and -CR⁴=CR⁵- (where R⁴ and R⁵ each denote a hydrogen atom or a substituent). A group comprised of a combination of a polymerizable group and one or more from among -CR²₂- (where R² denotes a hydrogen atom or a substituent), -CO-, -O-, and a phenylene group is preferable.

R² denotes a hydrogen atom or a substituent, and preferably denotes a hydrogen atom or a hydroxy group.

At least one instance of R¹ preferably contains a hydroxy group. Incorporation of a hydroxy group enhances the curing rate of the organic layer.

The molecular weight of at least one instance of R¹ is preferably 10 to 250, more preferably 70 to 150.

R¹ is preferably bonded in at least the para position.

n denotes an integer of from 0 to 5, preferably an integer of from 0 to 2, more preferably 0 or 1, and further preferably, each instance denotes 1.

In the compound denoted by general formula (2), at least two instances of R¹ are preferably identical structures. It is preferable for each instance of n to denote 1, and for at least two of the four instances of R¹ to be identical structures. It is more preferable for each instance of n to denote 1 and for all four instances of R¹ to be identical structures. The polymerizable group present in general formula (2) is preferably a (meth)acryloyl group or an epoxy group, and more preferably a (meth)acryloyl group. The number of polymerizable groups present in general formula (2) is preferably 2 or more and more preferably 3 or more. The upper limit has not been specifically established, but 8 or fewer are preferable and 6 or fewer are more prefereable.

The molecular weight of the compound denoted by general formula (2) is preferably 600 to 1,400, and more preferably 800 to 1,200.

The composition may contain only one or two or more of the compounds denoted by general formula (2) in the present invention. As a composition containing two or more, an example includes a composition containing a compound containing instances of R¹ that are of identical structure and in which the number of instances of R¹ varies, as well as isomers thereof.

Specific examples of compounds denoted by general formula (2) are given below. However, the present invention is not limited thereby. The compounds show examples in which the four instances of n in general formula (2) all denote 1. However, compounds in which one, two, or three of the four instances of n in general formula (2) denote 0 (such as bifunctional and trifunctional compounds), and compounds in which one, two, three, or more of the four instances of n in general formula (2) denote an integer of two or more (compounds in which there are two or more bonds on one ring of R¹, such as pentafunctional and hexafunctional compounds) are also examples of preferable compounds in the present invention.

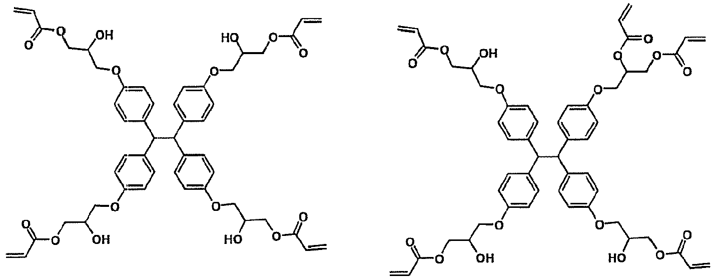

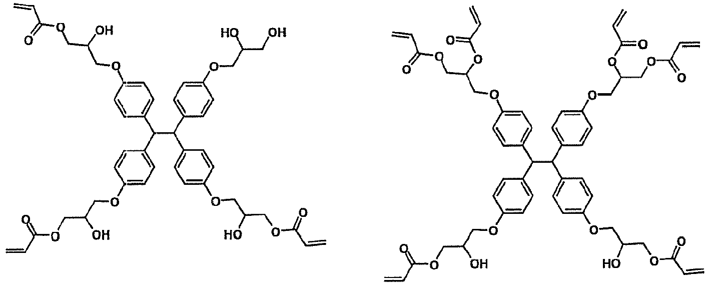

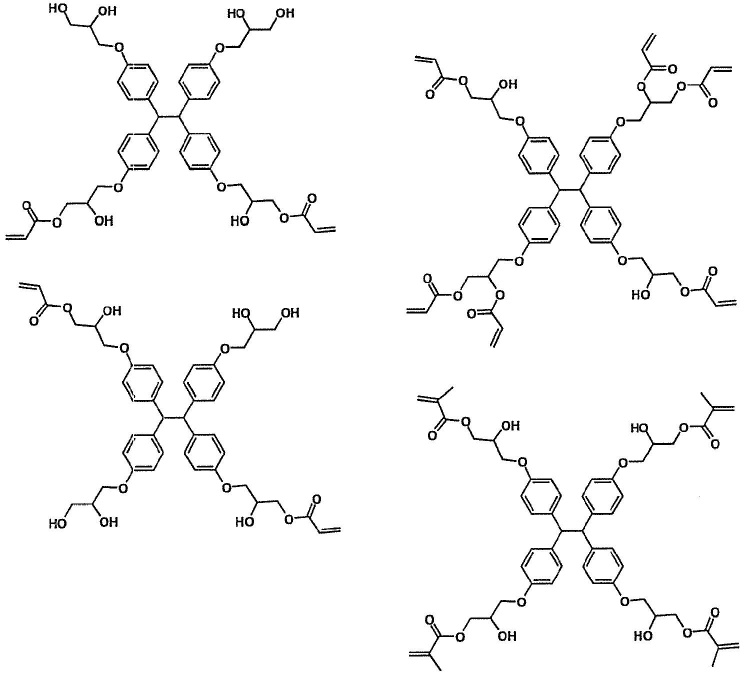

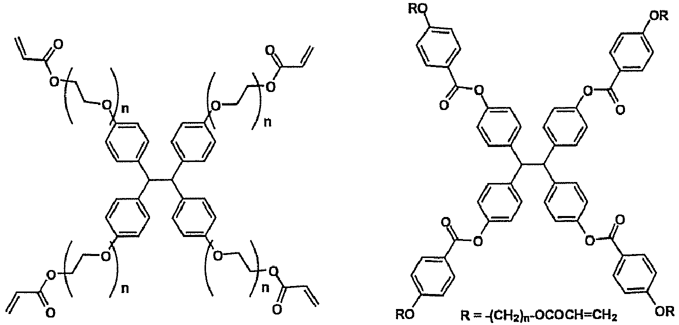

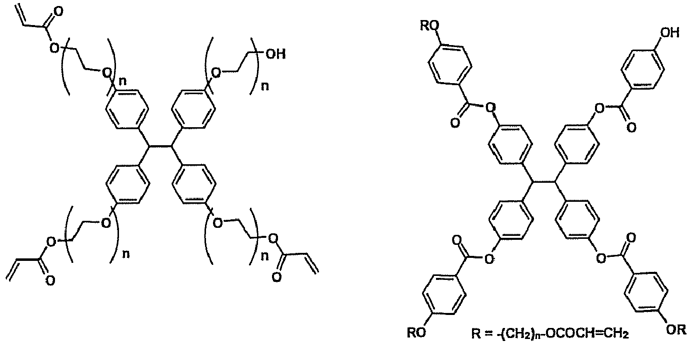

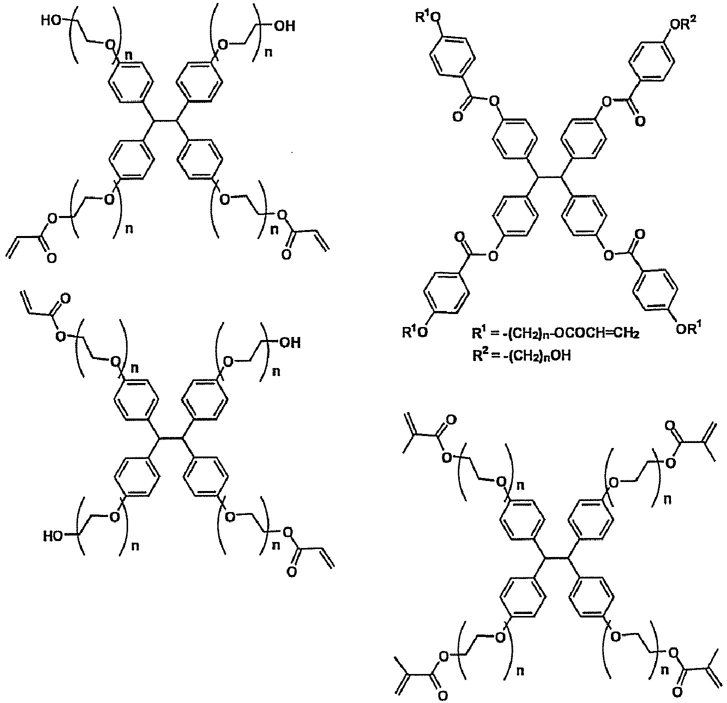

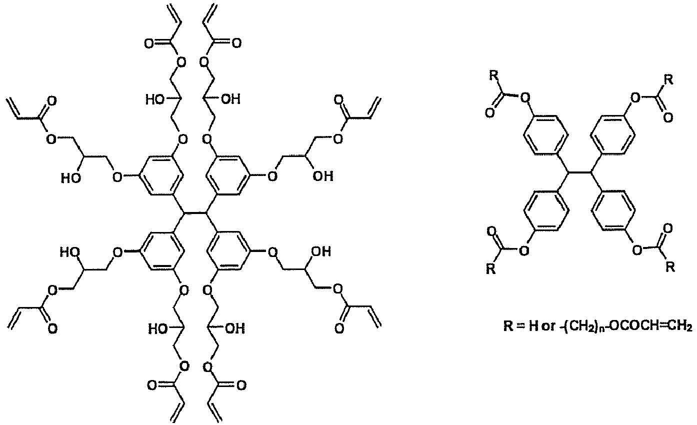

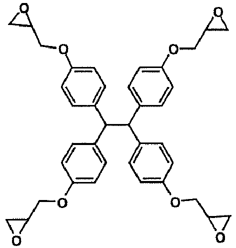

The compound denoted by general formula (2) above is available as a commercial product. The above compound can also be synthesized by known methods. For example, epoxy acrylates can be obtained by reacting an epoxy compound with acrylic acid. Normally, in the course of the reaction, bifunctional, trifunctional, pentafunctional, isomers, and the like of these compounds are produced. When it is desirable to separate these isomers, column chromatography can be employed. In the present invention, they can also be employed as a mixture.

### (The polymerization initiator)

The polymerizable composition in the present invention normally contains a polymerization initiator. When a polymerization initiator is employed, the content thereof is preferably 0.1 mol% or more, and more preferably 0.5 to 2 mol%, of the combined quantity of compounds contributing to polymerization. By employing such a composition, the polymerization reaction taking place via reactions producing active components can be suitably controled. Examples of photopolymerization initiators include the Irgacure series sold by Ciba Specialty Chemicals (such as Irgacure 651, Irgacure 754, Irgacure 184, Irgacure 2959, Irgacure 907, Irgacure 369, Irgacure 379, and Irgacure 819); the Darocure series (such as Darocure TPO and Darocure 1173); Quantacure PDO; and the Ezacure series sold by Lamberti Corportion (such as Ezacure TZM, Ezacure TZT, and Ezacure KTO46).

In the present invention, a polymerizable composition comprising a silane coupling agent, a polymerizable compound, and a polymerization initiator is cured with light (such as UV rays), an electron beam, or heat. Of these, curing with light is preferable. In particular, curing after heating the polymerizable composition to a temperature of 25°C or higher (such as 30 to 130°C) is preferable. The use of such a configuration causes the hydrolysis reaction of the silane coupling agent to progress, effectively curing the polymerizable composition and permitting film formation without damaging the substrate film or the like.

It is preferable for the polymerizable composition employed in the present invention to essentially not contain any silane coupling agent in addition to the silane coupling agent denoted by general formula (1). The term "essentially not contain" means, for example, 0.1 weight% or less of all components of the polymerizable composition.

The light used in irradiation is normally UV radiation from a high or low-pressure mercury lamp. The irradiation energy is preferably 0.1 J/cm² or higher, more preferably 0.5 J/cm² or higher. When the polymerizable compound employed is a (meth)acrylate compound, atmospheric oxygen will impede polymerization. Thus, it is preferable to reduce the oxygen concentration or oxygen partial pressure during polymerization. When reducing the oxygen concentration during polymerization by nitrogen substitution method, an oxygen concentration of 2% or lower is preferable, and 0.5% or lower is more preferable. When reducing the oxygen partial pressure during polymerization by pressure reduction method, the total pressure is preferably 1,000 Pa or less, more preferably 100 Pa or less. Irradiation with energy of 0.5 J/cm² or more under reduced pressure conditions of 100 Pa or less to conduct UV polymerization is particularly preferable.

The organic layer in the present invention is preferably smooth with a high degree of film hardness. The smoothness of the organic layer is preferably a 1 µm square average roughness (Ra value) of less than 1 nm, more preferably less than 0.5 nm. The polymerization rate of the monomer is preferably 85% or higher, more preferably 88% or higher, further preferably 90% or higher, and still further preferably, 92% or higher. The "polymerization rate" referred to here means the proportion of reacted polymerizable groups among all polymerizable groups (such as acryloyl groups and methacryloyl groups) in the mixture of monomers. The polymerization rate can be quantified by the infrared absorption method.

The film thickness of the organic layer is not specifically limited. However, when too thin, it becomes difficult to achieve uniform thickness, and when too thick, cracks caused by external forces develop, compromising barrier properties. From such perspectives, the thickness of the organic layer is preferably 50 to 2,000 nm, more preferably, 200 to 1,500 nm.

The absence of protrusions and foreign matter such as particles on the surface of the organic layer is required. Thus, formation of the organic layer is preferably conducted in a clean room. The degree of cleanliness is preferably class 10,000 or better, preferably class 1,000 or better.

A high degree of hardness is preferable in the organic layer. When the degree of hardness of the organic layer is high, a smooth inorganic layer will be formed. As a result, the barrier capability has been found to improve. The degree of hardness of the organic layer can be denoted as a microhardness based on the nanoindentation method. The degree of microhardness of the organic layer is preferably 100 N/mm or higher, more preferably 150 N/mm or higher.

### (The inorganic layer)

The inorganic layer is normally a thin layer comprised of a metal compound. The inorganic layer can be formed using any method capable of forming the desired thin film. Examples include physical vapor deposition (PVD) methods such as the vapor deposition method, sputtering method, and ion plating method; various chemical vapor deposition (CVD) methods, and liquid deposition methods such as plating and sol-gel methods. Of these methods, the vacuum film formation method is particularly preferable in the present invention. The components contained in the inorganic layer include metal oxides, nitrides, and oxynitrides of Si and Al. These can contain other elements as secondary components.

The smoothness of the inorganic layer that is formed in the present invention is preferably less than 1 nm, more preferably 0.5 nm or less, as a 1 µm square average roughness (Ra value). The inorganic layer is preferably formed in a clean room. The cleanliness of the clean room is preferably class 10,000 or better, more preferably class 1,000 or better.

The thickness of the inorganic layer is not specifically limited. However, the single-layer thickness normally falls within a range of 5 to 500 nm, preferably 10 to 200 nm. The inorganic layer can be of a laminate structure comprised of multiple sublayers. In that case, the individual sublayers can be of identical or different composition.

### (Laminates of organic and inorganic layers)

Laminates of organic and inorganic layers can be formed by successively repeating an organic layer and inorganic layer based on a desired layer configuration.

In particular, a particularly high barrier property can be achieved by the alternating lamination of at least two organic layers and at least two inorganic layers.

### (Functional layers)

The barrier laminate of the present invention can comprise functional layers. Functional layers are described in detail in paragraphs 0036 to 0038 in Japanese Unexamined Patent Publication (KOKAI) No. 2006-289627. Examples of these additional functional layers include matting agent layers, protective layers, solvent-resistant layers, antistatic layers, leveling layers, adhesion-enhancing layers, light-blocking layers, antireflective layers, hardcoat layers, stress-relieving layers, antifogging layers, grime-preventing layers, printing layers, and highly adhesive layers.

### Applications of the barrier laminate

The barrier laminate of the present invention is normally disposed on a support and can be employed in various applications through selection of the support. In addition to substrate films, examples of supports include various devices and optical elements. Specifically, the barrier laminate of the present invention can be employed as the barrier layer of a gas barrier film. The gas barrier film and barrier laminate of the present invention can also be employed to seal devices requiring a barrier property. The gas barrier film and barrier laminate of the present invention can also be applied to optical elements. These will be specifically described below.

### <Gas barrier films>

A gas barrier film comprises a substrate film and a barrier laminate formed over the substrate film according to the claims. Figure 3 shows an example of the configuration of the gas barrier film of the present invention in the form of a configuration in which an organic layer and an inorganic layer are disposed in alternating fashion on a substrate film 5. Specifically, moving sequentially from the substrate film 5 side, an organic layer 6, an inorganic layer 1, an organic layer 2, and an inorganic layer 3 are disposed with mutually adjacent surfaces. Organic layer 6, also referred to as an undercoating layer, enhances adhesion between substrate film 5 and inorganic layer 13. Organic layer 6 can be an organic layer containing the silane coupling agent denoted by general formula (1) above, or some other organic layer.

In a gas barrier film, the barrier laminate of the present invention can be provided on just one side or both sides of the substrate film. The barrier laminate of the present invention can be laminated in the order of inorganic layer/organic layer from the substrate film side, or laminated in the order of organic layer/inorganic layer. The topmost layer of the barrier laminate of the present invention can be either an inorganic layer or an organic layer.

Further, the gas barrier film of the present invention is a film substrate having a barrier layer with the function of blocking atmospheric oxygen, moisture, nitrogen oxides, sulfur oxides, ozone, and the like.

The number of layers in the configuration of the gas barrier film is not specifically limited. Conventionally, from 2 to 30 layers are preferable and from 3 to 20 layers are more preferable.

The gas barrier film can include structural components in addition to the barrier laminate and substrate film (such as a functional layer such as a highly adhesive layer). Functional layers can be disposed on the barrier laminate, between the barrier laminate and the substrate film, or on the side of the substrate film on which the barrier laminate is not provided (the reverse side).

### (Plastic films)

Normally, a plastic film is employed as the substrate film for the gas barrier film of the present invention. Any plastic film that is capable of supporting a barrier laminate such as an organic layer and an inorganic layer can be suitably selected based on the use objective or the like without specific limitation of material, thickness or the like. Specific examples of the plastic film include polyester resins, methacrylic resins, methacrylic acid-maleic acid copolymers, polystyrene resins, transparent fluororesins, polyimides, fluorinated polyimide resins, polyamide resins, polyamide-imide resins, polyetherimide resins, cellulose acylate resins, polyurethane resins, polyetheretherketone resins, polycarbonate resins, alicyclic polyolefin resins, polyarylate resins, polyethersulfonate resins, polysulfone resins, cycloolefin polymers, fluorene ring-modified polycarbonate resins, alicyclic modified polycarbonate resins, fluorene ring-modified polyester resins, acryloyl compounds, and other thermoplastic resins.

When employing the gas barrier film of the present invention as the substrate of a device such as an organic EL element, described further below, the plastic film is preferably comprised of a heat-resistant material. Specifically, it is preferably comprised of a highly heat-resistant, transparent material with a glass transition temperature (Tg) of 100°C or higher and/or a coefficient of linear thermal expansion of 40 ppm/°C or less. The Tg and coefficient of linear thermal expansion can be adjusted by means of additives and the like. Examples of such thermoplastic resins include: polyethylene naphthalate (PEN: 120°C), polycarbonate (PC: 140°C), alicyclic polyolefins (such as Zeonoa 1600: 160°C, made by Zeon Corporation), polyarylate (PAr: 210°C), polyether sulfone (PES: 220°C), polysulfone (PSF: 190°C), cycloolefin copolymer (COC, compound described in Japanese Unexamined Patent Publication (KOKAI) No. 2001-150584: 162°C), polymide (such as Neoprim: 260°C, from Mitsubishi Gas Chemical Co.), fluorene ring-modified polycarbonate (BCF-PC, compound described in Japanese Unexamined Patent Publication (KOKAI) No. 2000-227603: 225°C), alicyclic modified polycarbonate (IP-PC, compound described in Japanese Unexamined Patent Publication (KOKAI) No. 2000-227603: 205°C), and acryloyl compounds (compound described in Japanese Unexamined Patent Publication (KOKAI) No. 2002-80616: 300°C or higher) (temperature given in parentheses is Tg). In particular, it is preferable to employ alicyclic polyolefins and the like when transparency is desirable.

When the gas barrier film of the present invention is employed in combination with a polarizer, the barrier laminate of the gas barrier film is preferably oriented toward the interior of the cell and disposed in the innermost position (adjacent to the device). Since the gas barrier film will be positioned further inside the cell than the polarizer, the retardation value of the gas barrier film will become important. In such a configuration, preferable examples of the mode of use of the gas barrier film include: a lamination of a gas barrier film using a substrate film with a retardation value of 10 nm or less and a circular polarizer (1/4 wavelength sheet + (1/2 wavelength sheet) + linear polarizer), or a use of a gas barrier film using a substrate film with a retardation value of 100 to 180 nm which can be used as a 1/4 wavelength sheet, in combination with a linear polarizer.

Examples of substrate films with retardation values of 10 nm or less include cellulose triacetate (Fujifilm: Fujitac), polycarbonate (Teijin Chemical: Pureace; Kaneka: Elmec), cycloolefin polymers (JSR: Arton; Zeon Corp.: Zeona), cycloolefin polymers (Mitsui Chemical: Apel (pellets); Polyplastic: Topas (pellets)), polyarylate (Unitika: U100 (pellets)), and transparent polyimide (Mitsubishi Gas Chemical: Neoprim).

Films obtained by suitably stretching the above films to adjust the retardation value to a desired level can be employed as 1/4 wavelength sheets.

The gas barrier film of the present invention can be employed in devices such as organic EL elements. Thus, the plastic film is preferably transparent. That is, the light transmittance thereof is normally 80% or more, preferably 85% or more, and more preferably, 90% or more. The light transmittance can be calculated by the method described in JIS-K7105. That is, an integrating sphere-type light transmittance measuring device can be employed to measure the total light transmittance and amount of scattered light, and the diffused transmittance is subtracted from the total light transmittance.

Even when the gas barrier film of the present invention is used in display applications, transparence is not necessarily required when the gas barrier film is not positioned on the observation side. Accordingly, in such cases, a non-transparent material can be employed as the plastic film. Examples of non-transparent materials include polyimides, polyacrylonitriles, and known liquid-crystal polymers.

The thickness of the plastic film employed in the gas barrier film of the present invention can be suitably selected based on the application, and is thus not specifically limited. However, it is conventionally 1 to 800 µm, preferably 10 to 200 µm. These plastic films may comprise functional layers such as transparent electrically conductive layers and primer layers. In addition to the above, functional layers in the form of those described in paragraphs 0036 to 0038 in Japanese Unexamined Patent Publication (KOKAI) No. 2006-289627 can be preferably employed.

The barrier laminate of the present invention can be preferably employed to seal elements that could deteriorate over time due to water, oxygen, and the like when used at ordinary temperature and pressure. Examples include organic EL elements, liquid-crystal display elements, solar cells, and touch panels.

The barrier laminate of the present invention can be used in device film sealing. This is a method in which the barrier laminate of the present invention is positioned on the surface of a device, with the device itself serving as a support. It is also possible to cover the device with a protective layer before providing the barrier laminate.

The barrier laminate and gas barrier film of the present invention can be employed as device substrates or as films for sealing by a solid sealing method. "Solid sealing method" is a method by which a protective layer is formed on a device, after which an adhesive layer, a barrier laminate or a gas barrier layer are stacked and cured. The adhesive is not specifically limited. Examples include thermosetting epoxy resins and photo-currable acrylate resins.

When conventional barrier laminates and gas barrier films are incorporated into devices and, in that state, heated to a temperature of 80°C or higher, or even 100°C or higher, they release alcohol gas and end up damaging the device. However, even when heated to such elevated temperatures, the barrier substrate and gas barrier film of the present invention do not release large quantities of alcohol gas, thereby effectively inhibiting device damage.

### (Organic EL elements)

An example of an organic EL element employing a gas barrier film is described in detail in Japanese Unexamined Patent Publication (KOKAI) No. 2007-30387. In the process of manufacturing an organic EL element, there are a drying step following the ITO etching step and other steps conducted under highly humid conditions. Thus, use of the gas barrier film of the present invention is extremely advantageous.

### (Liquid-crystal display elements)

A reflective type liquid-crystal display device has a configuration that is sequentially comprised of, from the bottom up, a substrate, reflective electrode, lower orientation film, liquid-crystal layer, upper orientation film, transparent electrode, upper substrate, λ/4 plate, and polarizing film. The gas barrier film of the present invention can be employed as the transparent electrode substrate and upper substrate. In the case of a color display, a color filter layer is further preferably disposed between the reflective electrode and lower orientation film, or between the upper orientation film and transparent electrode. A transparent liquid-crystal display device has a configuration that is sequentially comprised of, from the bottom up, a backlight, polarizer, λ/4 plate, lower transparent electrode, lower orientation layer, liquid-crystal layer, upper orientation layer, upper transparent electrode, upper substrate, λ/4 plate, and polarizing film. Therein, the substrate of the present invention can be employed as the upper transparent electrode and the upper substrate. In the case of a color display, a color filter layer is further preferably disposed between the lower transparent electrode and the lower orientation film, or between the upper orientation film and the transparent electrode. Although not specifically limited, the type of liquid-crystal cell is preferably of the TN (twisted nematic), STN (super twisted nematic), HAN (hybrid aligned nematic), VA (vertical alignment), ECB (electrically controlled birefringence), OCB (optically compensated bend), IPS (in-plane switching), or CPA (continuous pinwheel alignment) type.

### (Solar cells)

The barrier laminate and gas barrier film of the present invention can be employed as sealing films for solar cell elements. Here, sealing is preferably conducted such that the adhesive layer of the barrier laminate and gas barrier film of the present invention is on the side closest to the solar cell element. For solar cells, which are required to be able to withstand a certain degree of heat and humidity, the barrier laminate and gas barrier film of the present invention are suitable. Although not specifically limited, examples of the solar cell elements in which the barrier laminate and gas barrier film of the present invention are employed include single-crystal silicon solar panel elements, polycrystalline silicon solar cell elements, single-junction type and tandem-structure type amorphous silicon solar cell elements, gallium-arsenic (GaAs) and indium-phosphorus (InP) and other group III-V compound semiconductor solar cell elements, cadmium-telluride (CdTe) and other group II-VI compound semiconductor solar cell elements, copper/indium /selenium (so-called "CIS system"), copper/indium/gallium/selenium (so-called "CIGS system"), copper/indium/gallium/selenium/sulfur (so-called "CIGSS system"), and other group I-III-VI compound semiconductor solar cell elements, dye-sensitized type solar cell elements, and organic solar cell elements. Of these, the above solar cell element is preferably a copper/indium/selenium (so-called "CIS system"), copper/indium/gallium/selenium (so-called "CIGS system"), copper/indium/gallium/selenium/sulfur (so-called "CIGSS system"), or other group I-III-VI compound semiconductor solar cell element.

### (Other)

Examples of other applications include the thin-film transistor described in Japanese Translated PCT Patent Application Publication (TOKUHYO) Heisei No. 10-512104; the touch panel described in publications such as Japanese Unexamined Patent Publication (KOKAI) Nos. Heisei 5-127822 and 2002-48913; and the electronic paper described in Japanese Unexamined Patent Publication (KOKAI) No. 2000-98326.

Further, a resin film such as a polyethylene film or a polypropylene film can be laminated with the barrier laminate or gas barrier film of the present invention for use as a sealing bag. For details, reference can be made to the description given in Japanese Unexamined Patent Publication (KOKAI) Nos. 2005-247409 and 2005-335134.

### <Optical elements>

A circular polarizer is an example of an optical element employing the gas barrier film of the present invention.

### (Circular polarizers)

The gas barrier film of the present invention can be employed as a substrate and laminated with a λ/4 plate and a polarizer to fabricate a circular polarizer. In that case, the lamination is conducted so that the slow axis of the λ/4 plate forms an angle of 45° with the absorption axis of the polarizer. For such a polarizer, a polarizer formed by extension in a direction forming an angle of 45° with the longitudinal direction can be preferably employed. By way of example, the polarizer described in Japanese Unexamined Patent Publication (KOKAI) No. 2002-865554 can be preferably employed.

### Examples

The present invention is described with greater specificity below through Examples.

### Example 1

### (Preparation of an organic layer coating composition)

A composition comprising 100 weight parts of a polymerizable compound (trimethylolpropane triacrylate (TMPTA) made by Daicel-Cytec), a photopolymerization initiator (Irgacure 184 made by Ciba Chemicals), 3 weight parts of the silane coupling agent indicated below, and methyl ethyl ketone (MEK) was prepared. The quantity of MEK was adjusted to yield a dry film thickness of 1 µm and the quantity of photopolymerization initiator employed was 3 weight% of the composition.

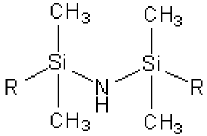

In the above formula, R denotes CH₂CHCOOCH₂.

The above silane coupling agent was synthesized with reference to the method described in Japanese Unexamined Patent Publication (KOKAI) No. 2009-67778.

### (Formation of first layer)

The organic layer coating composition obtained above was applied with a dye coater and dried on a polyethylene naphthalate film (Teonex Q65FA made by Teijin-DuPont, 100 µm in thickness, 1,000 mm in width). It was then cured with ultraviolet radiation. The film was then rolled up while maintaining a constant winding tension over the winding diameter.

### (Formation of a second layer)

An inorganic layer was formed on the surface of the above organic layer. The above first layer was placed in the feeding part of a vacuum film forming device. Once a vacuum had been generated within the vacuum film forming device, a SiN film was formed by CVD method over a 50 nm scope, and winding was conducted following film formation.

### (Formation of third layer)

An organic layer was formed on the surface of the above inorganic layer. The organic layer coating composition was applied so as to produce a coating 10 µm in thickness, yielding a dry film 1 µm in thickness. The drying temperature following coating was adjusted with dry air and maintained at 30°C or higher. Heating was conducted for 3 minutes. Subsequently, the film was cured in a UV radiation curing device adjusted to the same temperature as for the first layer, and rolled.

The adhesion and water vapor permeability of the gas barrier film obtained were evaluated by the following methods.

### <Adhesion evaluation>

Evaluation was conducted according to the method of JIS K5400. The surface of the film was scarred at 1 mm intervals in two directions at 90° to each other on the barrier layer side of the gas barrier film to prepare a grid with 100 squares each 1 mm in width. Mylar tape (polyester tape No. 31B made by Nitto Denko) 2 cm in width was applied on the grid and then peeled off. The number of squares of the organic layer that remained was evaluated.
- ⊚:: 100 squares
- ○:: 99 to 60 squares
- Δ:: 59 to 20 squares
- X:: 19 to 0 squares

### < Measurement of water vapor permeation rate (barrier property) by calcium method>

The water vapor permeation rate (g/m²/day) was measured by the method described by G. NISATO, P.C.P BOUTEN, P.J. SLIKKERVEER et al., SID Conference Record of the International Display Research Conference, pp. 1435-1438. A temperature of 40°C and a relative humidity of 90% were employed. The evaluation was conducted as follows:
X: 1.0 x 10⁻³ g/m² • day or more
ΔX: 2.0 x 10⁻⁴ g/m² • day or more but less than 1.0 x 10⁻³ g/m² • day
Δ: 1.0 x 10⁻⁴ g/m² • day or more but less than 2.0 x 10⁻⁴ g/m² • day
○: 5.0 x 10⁻⁵ g/m² • day or more but less than 1.0 x 10⁻⁴ g/m² • day
⊚: less than 5.0 x 10⁻⁵ g/m² • day

### (Examples 2 to 4)

The contents of TMPTA and the silane coupling agent in Example 1 were changed as set forth in the table; everything else was identically carried out.

### (Comparative Examples 1 to 3)

The silane coupling agent in Examples 2, 3, and 4 was replaced with an equal quantity of KR500 (made by Shin-Etsu Silicone); everything else was identically carried out.

The effects of degassing by heating were determined in the gas barrier films prepared in Examples 2 and 3 and in Comparative Examples 1 and 2 following heating for 5 hours at 100°C.

### (Examples 5 to 8, Comparative Examples 4 to 6)

Gas barrier films were formed by further forming a fourth layer as set forth below on the surface of the third layer of the gas barrier films prepared in Examples 1 to 4 and in Comparative Examples 1 to 3 above. The adhesion and water vapor permeability of the gas vapor films obtained were measured by the same methods as in Example 1.

### (Formation of fourth layer)

An inorganic layer was formed on the surface of the above organic layer. The gas barrier films prepared above were set in the feeding part of a vacuum film forming device. Once a vacuum had been generated within the vacuum film forming device, a SiN film was formed by CVD method over a 50 nm scope, and winding was conducted following film formation.

The effects of degassing by heating were determined in the gas barrier films prepared in Examples 5 to 8 and in Comparative Examples 4 to 6 following heating for 5 hours at 100°C.

### (Examples 9 to 11)

With the exception that the silane coupling agent in Examples 2 to 4 was replaced with an equal quantity of the silane coupling agent shown below, gas barrier films were formed in the same manner. The adhesion and water vapor permeability of the gas barrier films obtained were measured by the same methods as in Example 1.

The effects of degassing by heating were determined in the gas barrier films prepared in Examples 2 to 4 following heating for 5 hours at 100°C.

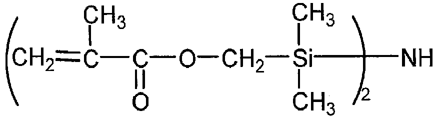

The results of the above are given in the following tables.

**Table 1**

| | First organic layer | Second inorganic layer | Third organic layer | | Adhesion | Moisture permeability | Status after heating |
|---|---|---|---|---|---|---|---|
| | Polymerizable compound | | Polymerizable compound | Silane coupling agent | | | |
| Example 1 | 100 | SiN | 96 | 3 | Δ | ○ | -- |
| Example 2 | 100 | SiN | 95 | 5 | ○ | ○ | No change |
| Example 3 | 100 | SiN | 90 | 10 | ○ | ○ | No change |
| Example 4 | 100 | SiN | 75 | 25 | ○ | ○ | -- |

**Table 2**

| | First organic layer | Second inorganic layer | Third organic layer | | Adhesion | Moisture permeability | Status after heating |
|---|---|---|---|---|---|---|---|
| | Polymerizable compound | | Polymerizable compound | Silane coupling agent | | | |
| Comp. 1 Example | 100 | SiN | 95 | 5 | ○ | ○ | Gave off gas |
| Comp. Example 2 | 100 | SiN | 90 | 10 | ○ | ○ | Gave off gas |
| Comp. Example 3 | 100 | SiN | 80 | 25 | ○ | ○ | -- |

**Table 3**

| | First organic layer | Second inorganic layer | Third organic layer | | Adhesion | Moisture permeability | Status after heating |
|---|---|---|---|---|---|---|---|
| | Polymerizable compound | | Polymerizable compound | Silane coupling agent | | | |
| Example 5 | 100 | SiN | 96 | 3 | ○ | ⊚ | No change |
| Example 6 | 100 | SiN | 95 | 5 | ○ | ⊚ | No change |
| Example 7 | 100 | SiN | 90 | 10 | ○ | ⊚ | No change |
| Example 8 | 100 | SiN | 75 | 25 | ⊚ | ⊚ | No change |

**Table 4**

| | First organic layer | Second inorganic layer | Third organic layer | | Adhesion | Moisture permeability | Status after heating |
|---|---|---|---|---|---|---|---|
| | Polymerizable compound | | Polymerizable compound | Silane coupling agent | | | |
| Comp. Example 4 | 100 | SiN | 95 | 5 | ○ | ⊚ | Fractured |
| Comp. Example 5 | 100 | SiN | 90 | 10 | ○ | ⊚ | Fractured |
| Comp. Example 6 | 100 | SiN | 80 | 20 | ○ | ⊚ | Fractured |

**Table 5**

| | First organic layer | Second inorganic layer | Third organic layer | | Adhesion | Moisture permeability | Status after heating |
|---|---|---|---|---|---|---|---|
| | Polymerizable compound | | Polymerizable compound | Silane coupling agent | | | |
| Example 9 | 100 | SiN | 95 | 5 | ○ | ○ | No change |
| Example 10 | 100 | SiN | 90 | 10 | ○ | ○ | No change |
| Example 11 | 100 | SiN | 75 | 25 | ○ | ○ | -- |

As will be clear based on the above tables, when the silane coupling agent denoted by general formula (1) was employed, gas barrier films having both good adhesion and good moisture penetration rates were obtained. Conversely, when a conventional silane coupling agent was employed, the moisture penetration rate tended to deteriorate. When an organic layer containing a silane coupling agent was sandwiched between inorganic layers, the gas barrier film was found to be damaged following heating.

### Evaluation in organic EL light-emitting elements

Organic EL elements were prepared using the gas barrier films obtained above. An ITO film (resistance: 30 Ω) was first formed by sputtering on the above gas barrier films. The following compound layers were then sequentially vapor deposited by the vacuum vapor deposition method on the substrate (anode).

### (First hole transmitting layer)

Copper-phthalocyanine: film thickness 10 nm

### (Second hole transmitting layer)

N,N'-Diphenyl-N,N'-dinaphthylbenzidine: film thickness 40 nm

### (Light-emitting and electron transmitting layer)

Tris(8-hydroxyquinolinato)aluminum: film thickness 60 nm

### (Electron injection layer)

Lithium fluoride: film thickness 1 nm

Metallic aluminum was vapor deposited on the compound layers to a thickness of 100 nm as a cathode, over which was applied by parallel plate CVD method a silicon nitride film 3 µm in thickness to prepare an organic EL element.

Next, a thermosetting adhesive (Epotec 310, Daizo-Nichimori) was employed to bond the gas barrier film prepared above to the organic EL element that had been fabricated, with the barrier laminate on the organic EL element side. The laminate was heated for 3 hours at 65°C to set the adhesive. A total of 10 organic EL elements that had been sealed in this manner were prepared.

As a result, when the gas barrier films of the comparative examples were employed, the gas barrier film employed as the ITO film substrate ended up being damaged, making it impossible to obtain a good element. Conversely, when the gas barrier film of the present invention was employed, the gas barrier film employed as the ITO film substrate was not damaged and a good organic EL element was obtained.

### Preparation of solar cells

The gas barrier films prepared above were used to prepare solar cell modules. Specifically, standard cure-type ethylene-vinyl acetate copolymer was employed as the filler for solar cell modules. Amorphous silicon solar cells were sandwiched between 10 cm square sheets of reinforced glass coated with 450 µm of ethylene-vinyl acetate copolymer and filled. The gas barrier film was then positioned thereon to prepare a solar cell module. The positioning was conducted under conditions of 150°C while drawing a vacuum for 3 minutes, and pressure was applied for 9 minutes. The solar cell modules, prepared by this method, functioned well and exhibited good electrical output characteristics even in an environment of 85°C and 85% relative humidity.

### Preparation of a sealing bag

Sealing bags were prepared using the gas barrier films fabricated above. The substrate film side of the gas barrier film was fused by the heat seal method to a bag (polyethylene bag) comprised of resin film and a sealing bag was prepared. A drug in the form of Cefazolin sodium (made by Otsuka Pharmaceutical Factory, Inc.) was sealed into the sealing bags obtained. The drug was stored for 6 months under conditions of 40°C and 75% relative humidity. Evaluation of change in the color tone revealed almost no change.

### Key to the Numbers

- 1: Inorganic layer
- 2: Organic layer
- 3: Inorganic layer
- 4: Alcohol
- 5: Substrate film
- 6: Organic layer
- 10: Barrier laminate

## Claims

1. A barrier laminate comprising an inorganic layer and an organic layer disposed on the surface of the inorganic layer, wherein the organic layer comprises a silane coupling agent denoted by general formula (1) below: 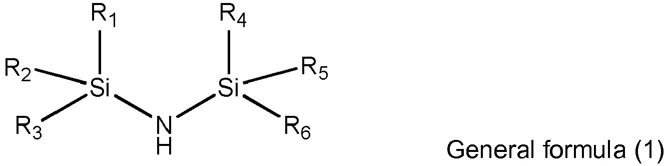
wherein each of R¹ to R⁶ denotes a substituted or unsubstituted alkyl group or aryl group; and
wherein the inorganic layer comprises a metal oxide, nitride, or oxynitride of Si or Al ;
**characterized in that** at least one from among R¹ to R⁶ is a substituent containing a (meth)acryloyloxy group.

2. A barrier laminate according to claim 1, wherein the organic layer is a layer obtained by curing a polymerizable composition comprising a polymerizable compound, the silane coupling agent denoted by general formula (1), and a polymerization initiator.

3. The barrier laminate according to claim 2, wherein the polymerizable compound is a (meth)acrylate compound.

4. The barrier laminate according to any one of claims 1 to 3, wherein the alkyl group is methyl group and the aryl group is phenyl group.

5. The barrier laminate according to any one of claims 1 to 4, which comprises a second inorganic layer on the surface of the organic layer.

6. The barrier laminate according to any one of claims 1 to 5, wherein at least two organic layers and two inorganic layers are laminated in alternating fashion.

7. A gas barrier film, comprising the barrier laminate according to any one of claims 1 to 6 disposed on a support.

8. A device comprising the barrier laminate according to any one of claims 1 to 6.

9. The device according to claim 8, wherein the device is an organic EL element or a solar cell element.

10. A sealing bag, comprising the barrier laminate according to any one of claims 1 to 6.

11. A method of manufacturing the gas barrier film according to claim 7, which comprises:
applying a polymerizable composition comprising a polymerizable compound, the silane coupling agent denoted by the general formula (1), and a polymerization initiator on a support;
heating to a temperature of 25°C or higher; and
curing with light rays, an electron beam, or heat.

## Patentansprüche

1. Sperrlaminat, umfassend eine anorganische Schicht und eine organische Schicht, die auf der Oberfläche der anorganischen Schicht angeordnet ist, worin die organische Schicht ein durch die nachstehende allgemeine Formel (1) bezeichnetes Silankupplungsmittel umfasst: 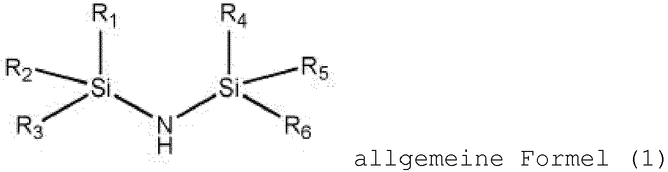
worin jedes von R¹ bis R⁶ eine substituierte oder unsubstituierte Alkylgruppe oder Arylgruppe bezeichnet; und
worin die anorganische Schicht ein Metalloxid, Nitrid oder Oxynitrid von Si oder Al umfasst;
**dadurch gekennzeichnet, dass** zumindest eines von R¹ bis R⁶ ein Substituent ist, der eine (Meth)acryloyloxygruppe enthält.

2. Sperrlaminat gemäß Anspruch 1, worin die organische Schicht eine Schicht ist, die durch Härten einer polymerisierbaren Zusammensetzung erhalten wird, umfassend eine polymerisierbare Verbindung, das durch die allgemeine Formel (1) bezeichnete Silankupplungsmittel und einen Polymerisationsinitiator.

3. Sperrlaminat gemäß Anspruch 2, worin die polymerisierbare Verbindung eine (Meth)acrylatverbindung ist.

4. Sperrlaminat gemäß irgendeinem der Ansprüche 1 bis 3, worin die Alkylgruppe eine Methylgruppe und die Arylgruppe eine Phenylgruppe ist.

5. Sperrlaminat gemäß irgendeinem der Ansprüche 1 bis 4, welches eine zweite anorganische Schicht auf der Oberfläche der organischen Schicht umfasst.

6. Sperrlaminat gemäß irgendeinem der Ansprüche 1 bis 5, worin zumindest zwei organische Schichten und zwei anorganische Schichten alternierend laminiert sind.

7. Gassperrfolie, umfassend das Sperrlaminat gemäß irgendeinem der Ansprüche 1 bis 6, angeordnet auf einem Träger.

8. Vorrichtung, umfassend das Sperrlaminat gemäß irgendeinem der Ansprüche 1 bis 6.

9. Vorrichtung gemäß Anspruch 8, worin die Vorrichtung ein organisches EL-Element oder ein Solarzellenelement ist.

10. Siegelbeutel, umfassend das Sperrlaminat gemäß irgendeinem der Ansprüche 1 bis 6.

11. Verfahren zur Herstellung der Gassperrfolie gemäß Anspruch 7, welches umfasst:
Auftragen einer polymerisierbaren Zusammensetzung, umfassend eine polymerisierbare Verbindung, das durch die allgemeine Formel (1) bezeichnete Silankupplungsmittel und einen Polymerisationsinitiator, auf einen Träger;
Erwärmen auf eine Temperatur von 25°C oder höher; und
Härten mit Lichtstrahlen, einem Elektronenstrahl oder Wärme.

## Revendications

1. Stratifié formant barrière comprenant une couche inorganique et une couche organique disposée dur la surface de la couche inorganique, dans lequel la couche organique comprend un agent de couplage silane dénoté par la formule générale (1) ci-dessous : 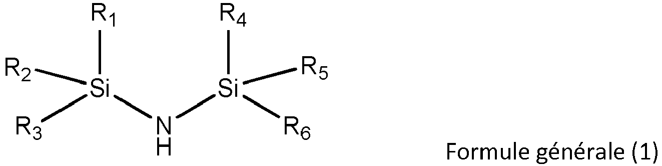
dans lequel chaque R¹ à R⁶ dénote un groupe aryle ou un groupe alkyle substitué ou non substitué ; et
dans lequel la couche inorganique comprend un oxyde métallique, un nitrure, ou un oxynitrure de Si ou Al ;
**caractérisé en ce que** au moins l'un parmi R¹ à R⁶ est un substituant contenant un groupe (méth)acryloyloxy.

2. Stratifié formant barrière selon la revendication 1, dans lequel la couche organique est une couche obtenue en durcissant une composition polymérisable comprenant un composé polymérisable, l'agent de couplage silane dénoté par la formule générale (1), et un initiateur de polymérisation.

3. Stratifié formant barrière selon la revendication 2, dans lequel le composé polymérisable est un composé (méth)acrylate.

4. Stratifié formant barrière selon l'une quelconque des revendications 1 à 3, dans lequel le groupe alkyle est un groupe méthyle et le groupe aryle est un groupe phényle.

5. Stratifié formant barrière selon l'une quelconque des revendications 1 à 4, dans lequel, qui comprend une deuxième couche inorganique sur la surface de la couche organique.

6. Stratifié formant barrière selon l'une quelconque des revendications 1 à 5, dans lequel au moins deux couches organiques et deux couches inorganiques sont laminées de façon alternée.

7. Film formant barrière aux gaz, comprenant le stratifié formant barrière selon l'une quelconque des revendications 1 à 6 disposé sur un support.

8. Dispositif comprenant le stratifié formant barrière selon l'une quelconque des revendications 1 à 6.

9. Le dispositif selon la revendication 8, dans lequel le dispositif est un élément électroluminescent organique ou un élément de cellule solaire.

10. Sac hermétique, comprenant le stratifié formant barrière selon l'une quelconque des revendications 1 à 6.

11. Procédé de fabrication du film formant barrière aux gaz selon la revendication 7, qui comprend :
l'application d'une composition polymérisable comprenant un composé polymérisable, l'agent de couplage silane dénoté par la formule générale (1), et un initiateur de polymérisation sur un support ;
le chauffage à une température de 25°C ou plus élevée ; et
le durcissement avec des rayons de lumière, un faisceau d'électrons, ou de la chaleur.
